# EUROPÄISCHE PATENTSCHRIFT

(11) **EP 0 749 584 B1**
(45) Veröffentlichungstag und Bekanntmachung des Hinweises auf die Patenterteilung: **17.09.1997**
(21) Anmeldenummer: 95910449.8
(22) Anmeldetag: 08.03.1995
(51) Int. Cl.: G01R 15/24

(54) **STRECKENNEUTRALER OPTISCHER SPANNUNGSSENSOR**
OPTICAL SENSOR FOR MEASURING VOLTAGE INDEPENDENTLY OF THE PATH OF TRANSMISSION
CAPTEUR OPTIQUE MESURANT LA TENSION INDEPENDAMMENT DE LA TRAJECTOIRE DE TRANSMISSION

(30) Priorität: 10.03.1994 DE 4408127
(43) Veröffentlichungstag der Anmeldung: 27.12.1996
(73) Patentinhaber: SIEMENS AKTIENGESELLSCHAFT, 80333 München (DE)
(72) Erfinder: BARTELT, Hartmut, D-91056 Erlangen (DE); BAUERSCHMIDT, Peter, D-91126 Schwabach (DE); LERCH, Reinhard, D-90562 Heroldsberg (DE)
(86) Internationale Anmeldenummer: DE9500324
(87) Internationale Veröffentlichungsnummer: WO9524654

(56) Entgegenhaltungen:
- EP-A- 0 067 683
- EP-A- 0 316 619
- EP-A- 0 345 142
- EP-A- 0 414 236
- DE-A- 4 229 449

## Beschreibung

Die Erfindung bezieht sich auf einen streckenneutralen optischen Spannungssensor für Spannungsmessungen auf Hochspannungspotential mit Potentialtrennung durch optische Signalübertragung, wobei ein schwingungsfähiges System mit einem Resonator aus piezoelektrischem Material verwendet wird.

In der elektrotechnischen Praxis stellt sich zunehmend das Problem, Spannungsmessungen auf Hochspannungspotential mit einfacher Potentialtrennung durchzuführen. Dafür bieten sich bekanntermaßen insbesondere optische Verfahren mit einer Signalübertragung über Lichtwellenleiter an.

Vom Stand der Technik sind zur Spannungsmessung mit Potentialtrennung polarisationsoptische Verfahren einerseits, die den sogenannten Pockels-Effekt ausnutzen (sh. **Monographie: Optical Fiber Sensors:** Systems and Applications, Vol. 2, Artech House (1989), Seiten 753 bis 756), und andererseits interferometrische Verfahren, die auf der piezoelektrischen Dehnung einer Lichtfaser beruhen (**Conf. Proceedings: 9th Optical Fiber Sensor Conference**, (Florenz, 4. bis 6.5.1993, Seiten 443 bis 446), bekannt und im einzelnen in der EP-A-0 316 619 beschrieben. Weiterhin ist aus der EP-A-0 414 236 ein optischer Wandler mit einem kapazitiven Spannungsteiler bekannt.

Schließlich ist aus der EP-A-0 345 142 ein Sensor für unterschiedlichste Anwendungen, d.h. ggfs. auch für eine Spannungsmessung, bekannt, der aus einem Resonator aus piezoelektrischem Material besteht und der mit einem Körper verbunden ist, der sich mechanisch mit der Meßgröße ändert. Dieser Körper ist insbesondere ein Gehäuse, über das indirekt eine Krafteinleitung zur Veränderung der Resonatorfrequenz erfolgt.

Bei den beiden erstgenannten Druckschriften wird im Ergebnis eine Intensitätsmodulation des Lichtes als Meßgröße genutzt. Intensitätsmodulierte Signale sind aber anfällig gegenüber Störungen und/oder Änderungen auf der Übertragungsstrecke, an der Lichtquelle und am Detektor. Bei der letztgenannten Druckschrift wird eine Frequenzcodierung realisiert. Durch die indirekte Krafteinwirkung über das Sensorgehäuse ergibt sich aber ein vergleichsweise komplexer Aufbau.

Aufgabe der Erfindung ist es demgegenüber, einen verbesserten optischen Spannungssensor zu schaffen, der einfach aufgebaut ist und insbesondere die Eigenschaft der sogenannten Streckenneutralität hat. Letztere Eigenschaft bedeutet, daß die Meßgröße ohne Störungen über längere Strecken übertragbar sein soll.

Die Aufgabe ist erfindungsgemäß bei einem optischen Spannungssensor der eingangs genannten Art dadurch gelöst, daß der als Volumenresonator ausgebildete Resonator als flache Scheibe in geeigneter Schnittebene mit optimaler E-Feld-Empfindlichkeit aus einer vorgegebenen Kristallgeometrie des piezoelektrischen Materials geschnitten ist, wobei die Eigenfrequenz der Scheibe durch die Scheibendicke vorgegeben ist und sich mit der anliegenden Meßspannung ändert, wobei die Meßspannung direkt über Flächenelektroden, welche die parallelen Oberflächen der Scheibe bedecken, in die Scheibe einleitbar ist und wobei die Frequenz als Meßgröße weitgehend unabhängig von streckenabhängigen Dämpfungen übertragbar ist.

Die Erfindung beruht auf der Erkenntnis, daß es aufgrund nichtlinearer Mechanismen unter dem Einfluß von elektrischen oder mechanischen Vorspannungen zu Frequenzverstimmungen resonanter Strukturen aus piezoelektrischem Material kommt. Insbesondere verändert sich die Eigenfrequenz mit der anliegenden Spannung und läßt sich als Meßgröße verwenden, sofern das schwingungsfähige System in geeigneter Geometrie vorliegt.

Besonders vorteilhaft ist bei der Erfindung, daß der Volumen-resonator optisch oder hybrid-optisch zu Schwingungen angeregt werden kann. Die Meßspannung wird dabei vorteilhafterweise kapazitiv an die Scheibe als Resonator angelegt, wobei bei Bedarf ein kapazitiver Spannungsteiler verwendet wird und gegebenenfalls dabei der Volumenresonator selbst als Sekundär-Kapazität dienen kann. Die Schwingungsfrequenz wird gleichermaßen optisch abgetastet und übertragen. Somit ist eine komplette Potentialtrennung realisiert.

Weitere Einzelheiten und Vorteile der Erfindung ergeben sich aus der nachfolgenden Figurenbeschreibung von Ausführungsbeispielen anhand der Zeichnung in Verbindung mit weiteren Unteransprüchen. Es zeigen
- Figur 1: das Prinzip eines streckenneutralen optischen Spannungswandlers als Blockschaltbild,
- Figur 2a und 2b: Impedanz-Frequenzdiagramme von scheibenförmigen 2 MHz-Resonatoren, welche die geometrische Optimierung verdeutlichen,
- Figur 3: einen optimierten 5 MHz-Quarz-Resonator mit einer Frequenzkurve entsprechend Figur 2b und
- Figur 4: eine Schaltung unter Verwendung von optischen Spannungssensoren mit Eliminierung von Temperatureffekten.

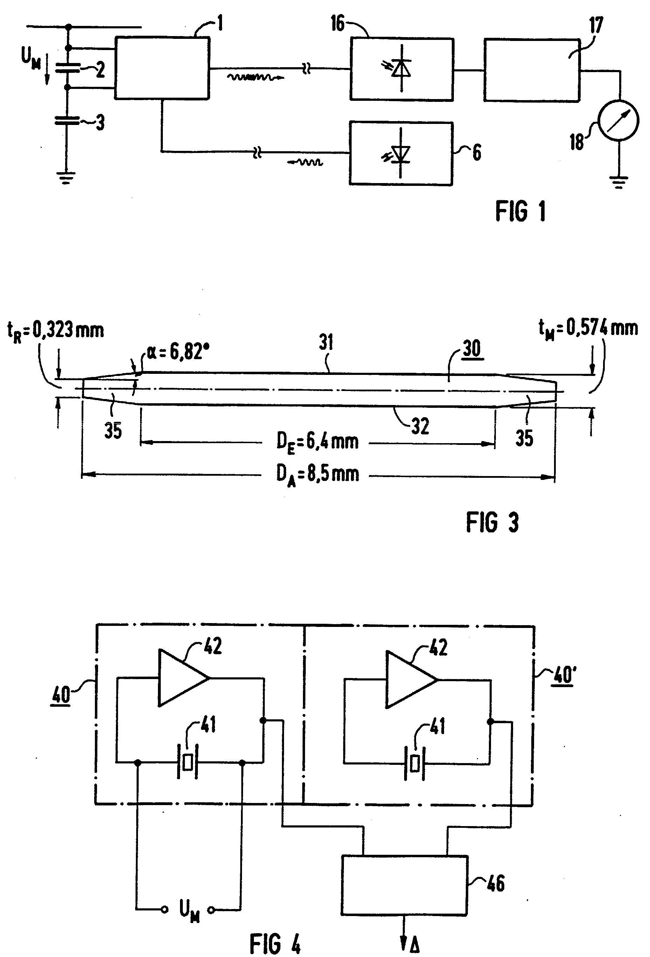

In Figur 1 kennzeichnet 1 einen Sensor mit Spannungs-/Frequenz-Umsetzung. Vorteilhafterweise ist der Sensor 1 kapazitiv an die Meßspannung angeschlossen, wobei aus zwei Kondensatoren 2 und 3 ein kapazitiver Spannungsteiler gebildet ist. Dabei kann gegebenenfalls der Sensor selbst als Kapazität 2 verwendet werden.

Der Sensor 1 wird optisch oder hybrid-optisch mit Energie versorgt. Der Begriff "hybrid-optisch" bedeutet dabei, daß mittels einer Einheit 6 Energie optisch übertragen und nach einer optoelektrischen Wandlung zur elektrischen Anregung des Sensors 1 verwendet wird.

Die vom Sensor 1 erhaltene Meßgröße ist ein frequenzmoduliertes Signal, das als Lichtsignal vom Sensor über längere Strecken zu einem optischen Empfänger 16 übertragen werden kann. Dem optischen Empfänger 16 schließt sich eine Einheit 17 zur Frequenzdetektion und ein Meßgerät 18 zur Ausgabe eines Spannungssignals an.

Der Sensor 1 besteht als Volumenresonator aus einem Material mit piezoelektrischem Effekt. Dafür wurde insbesondere einkristallines Quarz (SiO₂) erprobt. Alternativ kommt dafür auch einkristallines Lithium-Niobat (LiNbO₃) in Frage.

Es ist bekannt, daß die Resonatoreigenschaften variieren, je nachdem unter welcher Orientierung das schwingungsfähige System aus dem einkristallinen, trigonalen Kristall herausgeschnitten wird. Für optimale E-Feld-Empfindlichkeit der Eigenfrequenz kommt dafür insbesondere der sogenannte X-Cut, also ein Schnitt mit der kristallographischen x-Achse als Normale in Frage. Es lassen sich so Scheiben in geeigneter Geometrie präparieren.

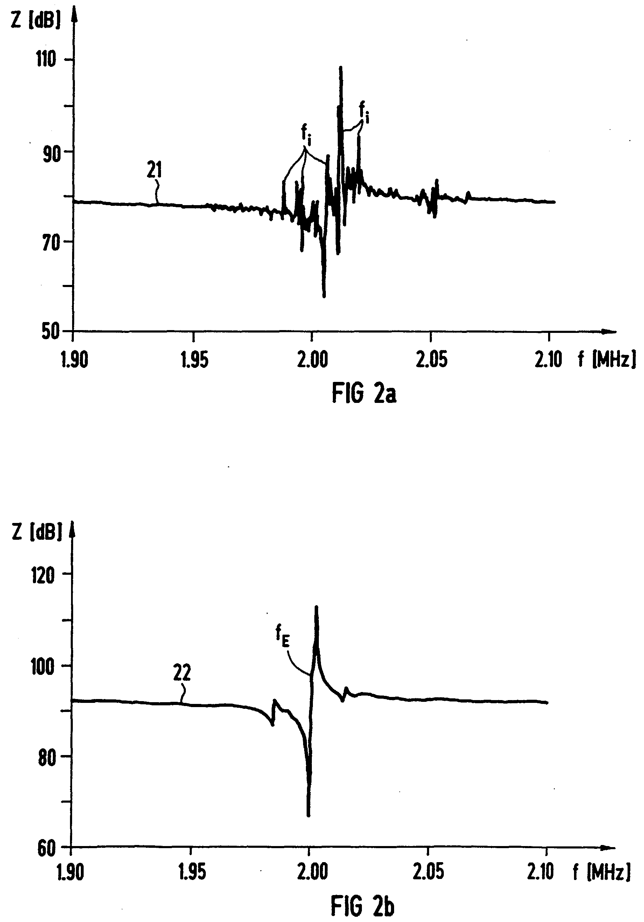

Die Meßkurven 21 und 22 der Figur 2a und 2b zeigen, daß besondere Maßnahmen getroffen werden müssen, um auswertefähige Meßgrößen zu erhalten: Bei einem 2 MHz-Resonator, der als Scheibe im X-Cut ausgebildet ist, ergibt sich ein Spektrum gemäß Figur 2a mit einer Anzahl diskreter Eigenfrequenzen fᵢ . Erst wenn der Resonator im X-Cut bezüglich seiner geometrischen Form optimiert ist, ergibt sich eine singuläre Eigenfrequenz f_{E} zur Erfassung und Übertragung als spannungsabhängige Meßgröße.

In Figur 3 zeigt 30 den Schnitt eines optimierten 5 MHz-Quarz-X-Cut-Resonators. Dieser ist in der Figur vorteilhafterweise in Rotationssymmetrie, d.h. mit runder Außenkontur, ausgebildet. Aber auch eine Rechteckform ist möglich.

Der X-Cut-Resonator 30 hat zwei parallele plane Oberflächen mit Innendurchmesser D = 6,4 mm, welche von Edelmetallelektroden 31 und 32, beispielsweise Goldelektroden, bedeckt sind. Der äußere Durchmesser beträgt D_{A} = 8,5 mm, wobei die Scheibe eine Dicke von t_{M} = 0,574 mm hat. Wichtig ist dabei, daß der äußere Randbereich 35 umlaufend abgeschrägt ist, so daß sich eine äußere Dicke der Scheibe 30 von t_{R} = 0,32 3 mm ergibt und etwa ein Abschrägungswinkel α = 6,82° vorliegt.

Die speziell für einen 5 MHz Quarz-Resonator optimierte Geometrie kann sich für andere Eigenfrequenzen und andere Materialien in vorgegebener Abhängigkeit ändern. Üblicherweise wird die Frequenzempfindlichkeit mit geringerer Dicke der Scheibe zunehmen, während aber gleichzeitig die Durchbruchsspannung abnimmt. Insofern läßt sich durch geeignete Geometrie eine für die jeweilige Nennspannung optimierte Frequenzempfindlichkeit erreichen. Dabei ist vorteilhaft, einen solchen Volumen-Resonator zu realisieren, bei dem die Schwingungsform im Dickenmode erfolgt. Ein derartiger Dickenmode eignet sich besser für eine optische Detektion.

Die als Hochspannungssensoren gemäß Figur 1 und Figur 3 zu verwendenden Volumenresonatoren besitzen üblicherweise auch eine Temperaturabhängigkeit, welche die Spannungsabhängigkeit überlagert und insofern nicht unbeachtlich ist. Die Eliminierung des Temperatureffektes kann in einfacher Weise über eine Differenzschaltung erfolgen, welche in Figur 4 dargestellt ist:

In Figur 4 kennzeichnet 40 eine erste Einheit und 40' eine zweite Einheit, die weitgehend identisch aufgebaut sind. Aus einer über den frequenzbestimmenden Quarz 41 rückgekoppelten Verstärkereinheit, beispielsweise Operationsverstärker 42, werden Oszillatoren gebildet, deren Frequenzen in gleicher Weise spannungs- und temperaturabhängig sind. Nur die Einheit 40 liegt an der Meßspannung, während die Einheit 40' als "Phantomschaltung" dient. Die Ausgangssignale beider Einheiten 40 werden über separate Kanäle auf einen Frequenzzähler 46 gegeben.

Voraussetzung ist, daß beide Einheiten 40 und 40' mit den Oszillatoren möglichst nah beieinanderstehen und somit gleiche Temperaturänderungen erfahren. Im Frequenzzähler 46 kann die Differenz des Frequenzsignals unter Meßpannung mit Temperaturbeeinflussung und des Frequenzsignals nur unter Temperaturbeeinflussung gebildet werden. Das Ausgangssignal Δ stellt dann eine temperaturunabhängige Meßgröße dar und ist das streckenneutrale Spannungssignal.

## Patentansprüche

1. Streckenneutraler optischer Spannungssensor für Spannungsmessungen auf Hochspannungspotential mit Potentialtrennung durch optische Signalübertragung, wobei ein schwingungsfähiges System mit einem Resonator aus piezoelektrischem Material verwendet wird, **dadurch gekennzeichnet**, daß der als Volumenresonator ausgebildete Resonator (1) als flache Scheibe (30) in geeigneter Schnittebene mit optimaler E-Feld-Empfindlichkeit aus einer vorgegebenen Kristallgeometrie des piezoelektrischen Materials geschnitten ist, wobei die Eigenfrequenz (f_{E}) der Scheibe (50) durch die Scheibendicke (t_{M}) vorgegeben ist und sich mit der anliegenden Meßspannung (U_{M}) ändert, wobei die Meßspannung (U_{M}) direkt über Flächenelektroden (31, 32), welche die parallelen Oberflächen der Scheibe (30) bedecken, in die Scheibe (30) einleitbar ist und wobei die Frequenz (f_{E}) als Meßgröße weitgehend unabhängig von streckenabhängigen Dämpfungen übertragbar ist.

2. Streckenneutraler optischer Spannungssensor nach Anspruch 1, **dadurch gekennzeichnet**, daß der Volumenresonator (1, 30) optisch zu Schwingungen angeregt wird.

3. Streckenneutraler optischer Spannungssensor nach Anspruch 1, **dadurch gekennzeichnet**, daß der Volumenresonator (1, 30) hybridoptisch zu Schwingungen angeregt wird.

4. Streckenneutraler optischer Spannungssensor nach Anspruch 1, **dadurch gekennzeichnet**, daß die Meßspannung kapazitiv an den Volumenresonator (1, 30) angelegt wird.

5. Streckenneutraler optischer Spannungssensor nach Anspruch 4, **dadurch gekennzeichnet**, daß die Meßspannung kapazitiv geteilt ist und daß der Volumenresonator (1, 30) als Teilkapazität verwendet wird..

6. Streckenneutraler optischer Spannungssensor nach Anspruch 1, **dadurch gekennzeichnet**, daß die Schwingungsfrequenz (f_{E}) optisch abgetastet und übertragen wird.

7. Streckenneutraler optischer Spannungssensor nach Anspruch 1, **dadurch gekennzeichnet**, daß das piezoelektrische Material Quarz (SiO₂) ist.

8. Streckenneutraler optischer Spannungssensor nach Anspruch 1, **dadurch gekennzeichnet**, daß das piezoelektrische Material Lithium-Niobat (LiNbO₃) ist.

9. Streckenneutraler optischer Spannungssensor nach Anspruch 7, **dadurch gekennzeichnet**, daß bei Verwendung von Quarz die geeignete Schnittebene ein sogenannter X-Cut ist.

10. Streckenneutraler optischer Spannungssensor nach Anspruch 1, **dadurch gekennzeichnet**, daß die Scheibe (30) eine runde Außenkontur hat.

11. Streckenneutraler optischer Spannungssensor nach Anspruch 10, **dadurch gekennzeichnet**, daß der äußere Ringbereich(35) der Scheibe gegenüber dem Innenbereich der Scheibe (30) abgeschrägt ist.

12. Streckenneutraler optischer Spannungssensor nach Anspruch 11, **dadurch gekennzeichnet**, daß die Scheibe (30) eine Stärke t_{M} < 1 mm, vorzugsweise zwischen 0,5 und 0,65 mm, und die Abschrägung einen Winkel α < 10°, vorzugsweise zwischen 4,5 und 9°, hat.

## Claims

1. Optical voltage sensor, which has path neutrality, for voltage measurements at high-voltage potential with potential isolation by means of optical signal transmission, wherein a system that is capable of oscillating is used that has a resonator made of piezoelectric material, characterised in that the resonator (1), which is formed as a volume resonator, is cut as a flat disc (30) in a suitable cutting plane with optimum E-field sensitivity from a given crystal geometry of the piezoelectric material, wherein the natural frequency (f_{E}) of the disc (50) (sic) is preset by the disc thickness (t_{M}) and changes with the measurement voltage (U_{M}) that is applied, wherein the measurement voltage (U_{M}) can be introduced into the disc (30) directly by way of surface electrodes (31, 32), which cover the parallel surfaces of the disc (30), and wherein the frequency (f_{E}) can be transmitted as a measured variable in a manner that is substantially independent of path-dependent attenuations.

2. Optical voltage sensor which has path neutrality according to claim 1, characterised in that the volume resonator (1, 30) is excited in an optical manner to give rise to oscillations.

3. Optical voltage sensor which has path neutrality according to claim 1, characterised in that the volume resonator (1, 30) is excited in a hybrid-optical manner to give rise to oscillations.

4. Optical voltage sensor which has path neutrality according to claim 1, characterised in that the measurement voltage is excited capacitively at the volume resonator (1, 30).

5. Optical voltage sensor which has path neutrality according to claim 4, characterised in that the measurement voltage is divided capacitively and in that the volume resonator (1, 30) is used as a partial capacitor.

6. Optical voltage sensor which has path neutrality according to claim 1, characterised in that the oscillation frequency (f_{E}) is scanned and transmitted optically.

7. Optical voltage sensor which has path neutrality according to claim 1, characterised in that the piezoelectric material is quartz (SiO₂).

8. Optical voltage sensor which has path neutrality according to claim 1, characterised in that the piezoelectric material is lithium niobate (LiNbO₃).

9. Optical voltage sensor which has path neutrality according to claim 7, characterised in that when quartz is used the suitable cutting plane is a so-called X-cut.

10. Optical voltage sensor which has path neutrality according to claim 1, characterised in that the disc (30) has a round outer contour.

11. Optical voltage sensor which has path neutrality according to claim 10, characterised in that the outer ring area (35) of the disc is bevelled in relation to the inner area of the disc (30).

12. Optical voltage sensor which has path neutrality according to claim 11, characterised in that the disc (30) has a thickness t_{M} < 1mm, preferably between 0.5 and 0.65 mm, and the bevel has an angle α < 10°, preferably between 4.5 and 9°.

## Revendications

1. Capteur optique de tension indépendant de la distance, pour des mesures de la tension sur un potentiel haute tension avec coupure du potentiel par transmission optique du signal, un système capable d'osciller comportant un résonateur en un matériau piézoélectrique étant utilisé, caractérisé en ce que le résonateur (1) formé en tant que résonateur volumique est coupé en tant que disque plat (30) dans un plan de coupe approprié avec une sensibilité optimale du champ E à partir d'une géométrie cristalline prescrite du matériau piézoélectrique, la fréquence propre (f_{Z}) du disque (50) étant prescrite par l'épaisseur (t_{M}) du disque et changeant avec la tension (U_{M}) de mesure appliquée, la tension (U_{M}) de mesure étant introduite directement dans le disque (30) par l'intermédiaire d'électrodes (31,32) de surface, qui recouvrent les surfaces parallèles du disque (30), et la fréquence (f_{Z}) pouvant être transmise dans une large mesure indépendamment d'atténuations dépendant de la distance.

2. Capteur optique de tension indépendant de la distance suivant la revendication 1, caractérisé en ce que le résonateur volumique (1,30) est excité optiquement pour produire des oscillations.

3. Capteur optique de tension indépendant de la distance suivant la revendication 1, caractérisé en ce que le résonateur volumique (1,30) est excité hybrido-optiquement pour produire des oscillations.

4. Capteur optique de tension indépendant de la distance suivant la revendication 1, caractérisé en ce que la tension de mesure est appliquée capacitivement au résonateur (1,30) volumique.

5. Capteur optique de tension indépendant de la distance suivant la revendication 4, caractérisé en ce que la tension de mesure est divisée capacitivement et le résonateur volumique (1,30) est utilisé comme une capacité partielle.

6. Capteur optique de tension indépendant de la distance suivant la revendication 1, caractérisé en ce que la fréquence (f_{E}) d'oscillation est échantillonnée et transmise optiquement.

7. Capteur optique de tension indépendant de la distance suivant la revendication 1, caractérisé en ce que le matériau piézoélectrique est du quartz (SiO₂).

8. Capteur optique de tension indépendant de la distance suivant la revendication 1, caractérisé en ce que le matériau piézoélectrique est du niobate de lithium (LiNbO₃).

9. Capteur optique de tension indépendant de la distance suivant la revendication 7, caractérisé en ce que lorsque l'on utilise du quartz, le plan de coupe approprié est ce que l'on appelle une coupe X.

10. Capteur optique de tension indépendant de la distance suivant la revendication 1, caractérisé en ce que le disque (30) a un contour extérieur rond.

11. Capteur optique de tension indépendant de la distance suivant la revendication 10, caractérisé en ce que la zone (35) annulaire extérieure du disque est biseautée par rapport à la zone intérieure du disque (30).

12. Capteur optique de tension indépendant de la distance suivant la revendication 11, caractérisé en ce que le disque (30) a une épaisseur t_{M} < 1 mm, de préférence comprise entre 0,5 et 0,65 mm et le biseau a un angle α < 10°, de préférence compris entre 4,5 et 9°.
